# EUROPEAN PATENT SPECIFICATION

(11) **EP 1 450 278 B1**
(45) Date of publication and mention of the grant of the patent: **24.04.2013**
(21) Application number: 04005293.8
(22) Date of filing: 23.01.2004
(51) Int. Cl.: G06F 11/14, G06F 17/50

(54) **Methods and apparatus for verifying the operation of a circuit design**
Verfahren und Gerät zur Prüfung der Funtionsfähigkeit eines Schaltungsentwurfs
Méthode et appareil pour vérifier le fonctionnement de la conception d'un circuit

(30) Priority: 23.01.2003 US 442176 P; 24.02.2003 US 373558
(43) Date of publication of application: 25.08.2004
(62) Divisional of application: 04001480.5
(73) Proprietor: Cadence Design Systems, Inc., San Jose, CA 95134 (US)
(72) Inventor: Beletsky, Platon, San Jose, CA 95123 (US); Kfir, Alon, San Jose California 95129 (US); Lin, Tsair-Chin, Saratoga California 95070 (US)
(74) Representative: Schmidtchen, Jürgen Christian

(56) References cited:
- EP-A2- 0 964 346
- US-A- 5 568 380
- US-B1- 6 446 249
- YANG Z; MIN B; CHOI G: "SI-EMULATION: SYSTEM VERIFICATION USING SIMULATION AND EMULATION", PROCEEDINGS INTERNATIONAL TEST CONFERENCE 2000. ITC 2000, 30 October 2000 (2000-10-30), pages 160-169, XP001049612, Baltimore, US
- CLEARY J; GOMES F; UNGER B; XIAO ZHONGE; THUDT R: "Cost of state saving and rollback", PROCEEDINGS OF 8TH WORKSHOP ON PARALLEL AND DISTRIBUTED SIMULATION, 1994, pages 94-101, Edinburgh, UK

## Description

The field of the invention relates generally to emulation systems, e.g., hardware logic emulation systems and software simulation systems used for verification of integrated circuit and electronic system designs and, more particularly, to methods and apparatus for restoring data stored in the memory circuits that form part of digital circuit designs from any given checkpoint back in time.

Hardware logic emulation systems are known devices that implement a user's design in a plurality of programmable integrated circuits. Such logic emulation systems are available from various vendors, including Cadence Design Systems, Inc., San Jose, California, United States of America, and others. Typical emulation systems utilize either programmable logic chips or processor chips which are programmably interconnected. In programmable logic chip (e.g., field programmable gate array, or FPGA) based emulation systems, the logic contained in the user's design (referred to herein as the "design under verification", or "DUV") is programmed into the logic chip such that the logic embodied in the DUV takes actual operating form in the programmable logic devices. In processor-based emulation systems, the user's design is processed so that its functionality appears to be created in the processors by calculating the outputs of the design. The logic itself is not implemented in a processor-based emulation system, which means that the DUV does not take actual operating form in the processors. Examples of hardware logic emulation systems using programmable logic devices can be seen in, e.g., United States Patent Nos. 5,109,353, 5,036,473, 5,475,830 and 5,960,191. Examples of hardware logic emulation systems using processor chips can be seen in, e.g., United States Patent Nos. 5,551,013, 6,035,117 and 6,051,030.

The article "Si-Emulation: System Verification Using Simulation and Emulation", Proceedings International Test Conference 2000, ITC 2000, 30 October 2000, pages 160-169, XP001049612, Baltimore, US, discloses a system-level verification framework that combines hard-wired (FPGA-based) emulation and gate-level simulation.

The article "Cost of State Saving & Rollback", Proceedings of 8th Workshop on Parallel and Distributed Simulation, 1994, pages 94-101, Edinburgh, UK, discloses approaches to state saving and rollback for a shared memory, optimistically synchronized, simulation executive.

EP 0 964 346 A2 discloses a reconstruction engine for a hardware circuit emulator.

The DUV is usually provided in the form of a netlist description of the design. The netlist may have been derived from many sources, including from a hardware description language. A netlist description (or "netlist") is a description of the circuit's components and electrical interconnections between the components. The components include all those circuit elements necessary for implementing a logic circuit, such as combinational logic (e.g., gates) and sequential logic (e.g., flip-flops and latches). In prior art emulation systems such as those manufactured and sold by Cadence Design Systems, Inc., the netlist is compiled such that it is placed in a form that can be used by the emulation system. In an FPGA-based emulator, the DUV is compiled into a form that allows the logic gates (both sequential and combinational) to be implemented in the FPGAs. In a processor-based emulation system, the DUV is compiled into a series of statements that will be executed by the processors on the processor chips. No logic is implemented into these processors.

One of the main uses for hardware logic emulation systems is to debug the DUV so that the user's design, once fabricated in actual silicon, contains no functional errors. Circuit designers have used emulators for many years to perform such debugging because the alternative, i.e., simulation, is much slower than emulation. Simulation is a software based approach, in which design and testbench are compiled into a machine executable model and executed in a workstation or PC. The testbench in an emulator is often represented as a target board, which interacts with the DUV directly.

In order to debug a DUV, the designer needs to look into activities of design signals over time. The reason for this is that digital circuits are driven by one or more clocks, and errors can occur at various transitions of the clocks driving the design, i.e., the DUV. The designer faces at least two issues when evaluating design signals over time. One issue is which signal to observe (i.e., which node in the DUV to observe). A second issue is when to observe the signals (i.e., at what clock transition and/or which confluence of events-- sometimes referred to as a trigger). These two issues impose serious challenges to simulation and emulation tools. First, circuit designs are typically very large (e.g., in the order of million gates). Second, the number of signals that the designer would like to observe is proportionally large. Third, since the time window in which design signals need to be observed (referred to herein as the "trace window") is difficult to predict prior to simulation or emulation, the designer who is debugging a design would prefer the trace window to be as large as possible.

In order to handle these issues, circuit designers have used various approaches. One such approach is to run the DUV lockstep in a simulator. With this approach, progress of simulation is controlled by the designer in an interactive operation. Designers can run the simulation, stop and observe signals, continue, and repeat the process. When the simulation stops, the designer can check the state of any signal in the circuit design. A second approach is to perform free running simulation with signal dump (e.g., copy the signals to an external memory). With the "free running" approach, simulation is executed freely without user intervention, and signals to be observed during simulation are dumped out during simulation. It is important to note that the signals to be dumped out must be specified before the simulation starts. These simulation approaches, while effective, are very slow. A third approach is to emulate the DUV using an emulator that allows full visibility for a fixed size of trace window. In this approach, the emulator is running freely, and signals generated by the DUV in the emulator that allow for full vision are saved for a certain period of time. A final approach is to emulate the DUV with an emulator that provides for limited visibility and replay. With this approach, limited information is saved during emulation. Designers might need to run the emulation a few times in order to obtain sufficient information for analysis.

The design verification industry has struggled for many years to provide visibility into DUVs. Prior art emulation systems provided some functionality in this area. Most prior art emulators provided various different methods for "probing" various nodes in the DUV so that the signals at that node were observable. For example, in United States Patent No. 5,425,036, a method was taught that allows signals to be probed by utilizing the "readback" function present in many FPGAs. In United States Patent No. 5,777,489, scan chains are fabricated onto the FPGA, which scan chains allow for tracing of all the state elements on the FPGA. Yet another method is described in United States Patent No. 5,943,490, which programs scan chains into the FPGA to allow tracing of selected subsets of state elements. In United States Patent No. 6,446,249, each of the logic elements (which implement the logic in the DUV) has a corresponding probe flip-flop, which can be randomly accessed by a probe sequence memory, the contents of which are read out in probe streams.

Regardless of which method the prior art systems used for capturing the values of various signals created by the DUV, no prior system can provide any debugging facilities for those portions of the DUV that include memories. In fact, the prior art emulators that even considered this problem would only treat such memories as "black-boxes", which means that the prior art emulators simply ignored the memories in the DUV and only allowed capture of the black-box's output signals. See, for example, United States Patent No. 6,061,511 (and specifically, Col. 6, Lines 21-30).

Because memories are an important part of any DUV, there is a need for a debugging method that allows an emulator to restore all the data stored in any location of the memories in the DUV. There is also a need for a debugging environment that does not require interruption or slow-down of the verification process for storing periodic snapshots. It is an object of the present invention to teach methods and apparatus that provide accessible information concerning signals (data) stored in the memory (or memories) of a DUV during functional verification of the DUV.

The various embodiments of the present invention provide novel methods and apparatus for restoring memories in a circuit design that is being emulated or simulated, thereby allowing visibility of the data stored therein. These embodiments allow memories to be restored for any given checkpoint (i.e., a point at which a trigger occurs) back in time within a predetermined time interval. The various embodiments can restore the data from the memories because, unlike the prior art, all write operations for each memory in the circuit design are captured during the verification process. For example, in some of the preferred embodiments, the write operations are captured in one or more circular buffer(s). When a checkpoint in the design occurs, memory playback is performed by applying the captured (i.e., stored) write operations to the DUV in reverse order (in a clock cycle by clock cycle fashion if desired). After all write operations are played back, the contents (i.e., stored data) of each design memory are restored to hold what was stored at the moment corresponding to the bottom (or first entry) of the circular buffer that captured the write operations. The length of the time interval for restoring memories is determined by the depth of the circular buffer.

Compared with the prior art, the various embodiments of the present invention allow visibility into more than just flip-flops and combinational signals. All memories of the DUV can be viewed for the entire duration of the trace window. It also allows for replay to begin at a point where the circuit designer would like.

In one aspect, a method for verifying that a circuit design functions as desired is disclosed for circuit designs that comprise a random access memory (RAM), in which the RAM comprises at least one write port and a plurality of memory locations for storing data. Each of the plurality of memory locations comprises an address. The method comprises emulating the circuit design in a functional verification system, such as but not limited to a hardware logic emulation system (e.g., a processor based emulation system of a field programmable gate array (FPGA) based emulation system). When (e.g., immediately prior to) writing data to a selected one of the plurality of memory locations in the RAM, the method comprises reading the data that will be written at the selected one of the plurality of memory locations in the RAM. The method also comprises storing the data read from the selected one of the plurality of memory locations in the RAM in a selected memory location within one or more buffer(s). After a checkpoint, the method comprises transferring the data stored at the selected memory location within the buffer to the selected one of the plurality of memory locations in the RAM. The method also comprises observing the data stored in the selected one of the plurality of memory locations in the RAM after the transferring step.

In another aspect, the step of reading the data stored at the selected one of the plurality of memory locations in the RAM step comprises, for each at least one write port in the RAM, inserting a corresponding shadow read port into the circuit design and conducting a read operation by the corresponding shadow read port. In this case, the data stored at the selected one of the plurality of memory locations in the RAM is read by the corresponding shadow read port.

In another aspect, the storing step further comprises arranging the selected memory location within the buffer so that data stored in the buffer is output in a last in, first out (LIFO) sequence.

In yet another aspect, the transferring step further comprises decrementing an address input to the buffer so that each selected memory location within the buffer is read out in a last in, first out manner. The method also comprises placing data from each selected memory location within the buffer on one of the at least one write ports on the RAM. The method also comprises writing the data from each selected memory location within the buffer placed on one of the at least one write ports on the RAM into the selected one of the plurality of memory locations in the RAM.

In another aspect, the observing step comprises observing each of the memory locations in the RAM after the writing step.

In another aspect, the storing step comprises arranging the selected memory location within the buffer so that data stored in the buffer is output in a first in, first out manner.

In yet another aspect, the transferring step further comprises incrementing an address input to the buffer so that each selected memory location within the buffer is read out in a first in, first out manner. The method also comprises placing data from each selected memory location within the buffer on one of the at least one write ports on the RAM. The method also comprises writing the data from each selected memory location within the buffer placed on one of the at least one write ports on the RAM into the selected one of the plurality of memory locations in the RAM. As a result, each memory location in the RAM is restored to the respective state stored therein at a predetermined time.

In another aspect, an apparatus for verifying that a circuit design functions as desired is disclosed, in which the circuit design comprises a random access memory (RAM) and the RAM comprises a write port having a data input and an address input, a read port and a plurality of memory locations for storing data. Each of the plurality of memory locations comprises an address. The write port has a data input and an address input. The apparatus comprises a shadow read port corresponding to the write port. The shadow read port comprises an address input that receives an address from the address input of the write port, and a data output. The apparatus also comprises one or more buffer(s). The one or more buffer(s) is (are) in communication with the address input of the RAM. The buffer also is in communication with the data output of the shadow read port. The buffer has an address output and a data output. The apparatus also comprises a first multiplexer feeding the address input on the write port. The first multiplexer has a first input in communication with the address output of the buffer. The first multiplexer has a second input in communication with the address input of the RAM. The apparatus comprises a second multiplexer feeding the data input on the write port. The second multiplexer has a first input in communication the data output of the buffer. The second multiplexer has a second input in communication with the data input of the RAM. The first multiplexer and the second multiplexer each have a select input that switches between a first mode and a second mode.

In another aspect, the buffer is in communication with a state machine.

In another aspect, the first mode allows signals from the address input of the RAM to be fed to the address input on the write port by the first multiplexer and signals from the data input of the RAM to be fed to the data input on the write port by the second multiplexer.

In another aspect, the second mode allows signals from the address output of the buffer to be fed to the address input on the write port by the first multiplexer and signals from the data output of the buffer to be fed to the data input on the write port by the second multiplexer.

In another aspect, the apparatus comprises a state machine in communication with the buffer.

In another aspect, the state machine controls which data and addresses stored in the buffer are read out of the address output and the data output of the buffer when the apparatus is in the second mode.

In another aspect, an apparatus for verifying that a circuit design functions as desired is disclosed, in which the circuit design comprises a RAM having a first write port and a second write port. The first write port comprises a first data input and a first address input. The second write port comprises a second data input and a second address input. The RAM also comprises first design data input, a first design address input, a second design data input and a second design address input, and a plurality of memory locations for storing data. Each of the plurality of memory locations comprises an address. The apparatus comprises a first shadow read port that corresponds to the first write port. The first shadow read port comprises an address input that receives an address from the first design address input. The first shadow read port further comprises a data output. The apparatus also comprises a second shadow read port that corresponds to the second write port. The second shadow read port comprises an address input that receives an address from the second design address input. The second shadow read port further comprises a data output. A first buffer in communication with the first design address input and with the data output of the first shadow read port is also present. The first buffer has an address output and a data output. The apparatus further comprises a second buffer. The second buffer is in communication with the second design address input. The second buffer is also in communication with the data output of the second shadow read port. The second buffer has an address output and a data output. A first multiplexer is included that feeds the first address input on the first write port. The first multiplexer has a first input in communication with the address output of the second buffer. The first multiplexer has a second input in communication with the first design address input. A second multiplexer feeds the first data input on the first write port. The second multiplexer has a first input in communication the data output of the second buffer. The second multiplexer has a second input in communication with the first design data input. A third multiplexer feeds the first address input on the second write port. The third multiplexer has a first input in communication with the address output of the first buffer. The third multiplexer has a second input in communication with the second design address input. A fourth multiplexer feeds the first data input on the second write port. The fourth multiplexer has a first input in communication with the data output of the first buffer. The fourth multiplexer has a second input in communication with the second design data input. The first multiplexer, the second multiplexer, the third multiplexer and the fourth multiplexer each have a select input that switches between a first mode and a second mode.

In another aspect, a method is disclosed for manipulating a circuit design comprising a RAM so that the circuit design can be debugged. The RAM comprises a write port and a plurality of memory locations for storing data. Each of the plurality of memory locations comprises an address. The method comprises inserting a shadow read port into the circuit design corresponding to the write port. The shadow read port comprises an address input that receives an address from the integrated circuit design. The shadow read port further comprises a data output. The method also comprises scheduling the shadow read port to read data stored at a selected memory address immediately prior to writing data into the selected memory address by the write port. The method also comprises interconnecting the data output of the shadow read port to a buffer. The buffer stores data read in the scheduling step in a selected memory location. The buffer comprises a data output and an address output. The method also comprises inserting a first multiplexer into the circuit design such that the first multiplexer feeds an address input on the write port. The first multiplexer has a first input in communication with an address input from the circuit design. The method also comprises inserting a second multiplexer into the circuit design such that the second multiplexer feeds a data input on the write port. The second multiplexer has a first input in communication with a data input from the circuit design. The method also comprises interconnecting the address output of the buffer to a second input of the first multiplexer. The method also comprises interconnecting the data output of the buffer to a second input of the second multiplexer. After a checkpoint, the method comprises transferring the data stored at the selected memory location within the buffer to the selected one of the plurality of memory locations in the RAM. The method further comprises observing the data stored in the selected one of the plurality of memory locations in the RAM after the transferring step.

In another aspect, the transferring step further comprises sending data stored at the selected memory locations within the buffer in a last in, first out order such that each of the selected one of the plurality of memory locations in the RAM is rewound (restored or returned) to states existing prior to the checkpoint.

In another aspect, the observing step further comprises sending data stored at the selected memory locations within the buffer in a first in, last out order such that each of the selected one of the plurality of memory locations in the RAM is restored to a state existing prior to the checkpoint.

In yet another aspect, a method for verifying that a circuit design functions as desired by using a functional verification system is disclosed for circuit designs comprising a random access memory (RAM). The RAM comprises at least one write port and a plurality of memory locations. The method comprises running the circuit design in the functional verification system. Immediately prior to writing data into the RAM, reading the data. The method also comprises storing the data in a buffer. At a checkpoint, the data stored in the buffer is read in reverse order from which the data was written into the buffer. As the data is read from the buffer, the data is written into the RAM.

In another aspect, the functional verification system comprises a hardware logic verification system. For example, the hardware logic verification system can comprise a processor based emulation system. The hardware logic verification system can also comprise a field programmable gate array (FPGA) based emulation system.

In yet another aspect, the functional verification system comprises a software simulator.

In yet another aspect, a method for verifying that a circuit design functions as desired is disclosed for circuit designs comprising a random access memory (RAM) having at least one write port and a plurality of memory locations. The method comprises running the circuit design in a first functional verification system. Immediately prior to writing data into the RAM, this data is read. The data is transferred to a system external from the first functional verification system. At a checkpoint, the data in the external system is reconstructed to create a reconstructed memory which corresponds to the plurality of memory locations of the RAM at a predetermined time. The reconstructing step comprises reading the previously stored data in a last in, first out order and writing the previously stored data into a memory in the external system, thereby creating the reconstructed memory.

In yet another aspect, after reconstructing the data, the reconstructed memory is transferred to the first functional verification system. The reconstructed memory is then written into the RAM.

In another aspect, after reconstructing the data, the reconstructed memory is transferred to a second functional verification system. The first functional verification system can, e.g., comprise a hardware logic verification system and the second functional verification system can comprise a software simulator.

In another aspect, a method for verifying that a circuit design functions as desired by using a functional verification system is disclosed for circuit designs comprising a random access memory (RAM) having at least one write port and a plurality of memory locations. The method comprises running the circuit design in the functional verification system and saving all write operations in a buffer. Each of the write operations comprises an address and data to be stored at the address. The address and the data to be stored at the address are stored in a temporal order corresponding to the order in which the write operations took place. An image of the RAM comprised of at least the addresses where the data changed during the write operation is reconstructed by replaying each of the write operations that are stored in the buffer. The image is written into the functional verification system.

Such a method may be implemented using a functional verification system that comprises a hardware logic verification system. The hardware logic verification system can be a processor based emulation system. The hardware logic verification system can also be a field programmable gate array (FPGA) based emulation system. In addition or in the alternative, the functional verification system can comprise a software simulator.

In another aspect, a method for verifying that a circuit design functions as desired by using a first functional verification system is disclosed for circuit designs comprising a random access memory (RAM) having at least one write port and a plurality of memory locations. The method comprises running the circuit design in the first functional verification system and saving all write operations in a buffer. Each of the write operations comprises an address and data to be stored at the address. The address and the data to be stored at the address are stored in a temporal order corresponding to the order in which said write operations took place. An image of the RAM comprised of at least the addresses where the data changed during the write operation is reconstructed by replaying each of the write operations that are stored in the buffer. The image is written into a second functional verification system.

In yet another aspect, the first functional verification system can comprise a hardware logic verification system. The hardware logic verification system can be a processor based emulation system. The hardware logic verification system can be a field programmable gate array (FPGA) based emulation system. The first functional verification system can also comprise a software simulator.

In addition or in the alternative, the second functional verification system can comprise a software simulator. The second functional verification system can also comprise a hardware logic verification system.

The above and other preferred features of the invention, including various novel details of implementation and combination of elements, will now be more particularly described with reference to the accompanying drawings and pointed out in the claims. It will be understood that the particular methods and circuits embodying the invention are shown by way of illustration only and not as limitations of the invention. As will be understood by those skilled in the art, the principles and features of this invention may be employed in various and numerous embodiments without departing from the scope of the invention.

Reference is made to the accompanying drawings in which are shown illustrative embodiments of aspects of the invention, from which novel features and advantages will be apparent.

Fig. 1 is a logic diagram showing a memory in a DUV after a shadow read port has been inserted therein.

Fig. 2 is a logic diagram showing a memory in a DUV with rewind logic inserted therein.

Fig. 3 is a logic diagram showing a multiport memory in a DUV with shadow read ports and rewind logic inserted therein.

Fig. 4 is a logic diagram showing circuitry that enables reconstruction of data stored in a memory of a DUV.

Fig. 5 is a block diagram illustrating a multiport memory.

Fig. 6 is a diagram showing how data stored in a circular buffer can be organized.

Fig. 7 is a timeline illustrating how memory rewind can take place over a time period.

Figure 8 is a table demonstrating how the system keeps track of the temporal ordering or the write operations in an embodiment disclosed herein.

Figure 9 is a schematic of a circuit used to implement multiport memories with single port RAMs.

Turning to the figures, the presently preferred apparatus and methods of the present invention will now be described.

As will now be seen, one embodiment has three major components. These components are "capture", "rewind" or "reconstruction", and "replay". Capture is performed while the DUV is running in the emulator and, in the context of the various embodiments of the present inventions, refers to the capture of memory write operations. As will be discussed further below, memory write operation data is (are) captured into one or more circular or linear buffer(s). The depth of the buffer determines the length of the time interval for rewind or reconstruction, i.e., the trace window.

Initially, it is noted that most of the discussion herein of the various embodiments will be made in the context of logic gates. In processor-based emulation systems, the methods are implemented by compiling the logic into Boolean expressions that will be executed by the processors. To the user of the emulation system, the output of the processor-based emulator is similar to that the output of an FPGA-based emulator. However, the manner in which the emulator's output was generated differs. In FPGA-based emulation systems, the logic referred to herein will be implemented by the logic elements (sometimes referred to as configurable logic blocks, or CLBs). The various embodiments disclosed herein can be applied to both types of emulators.

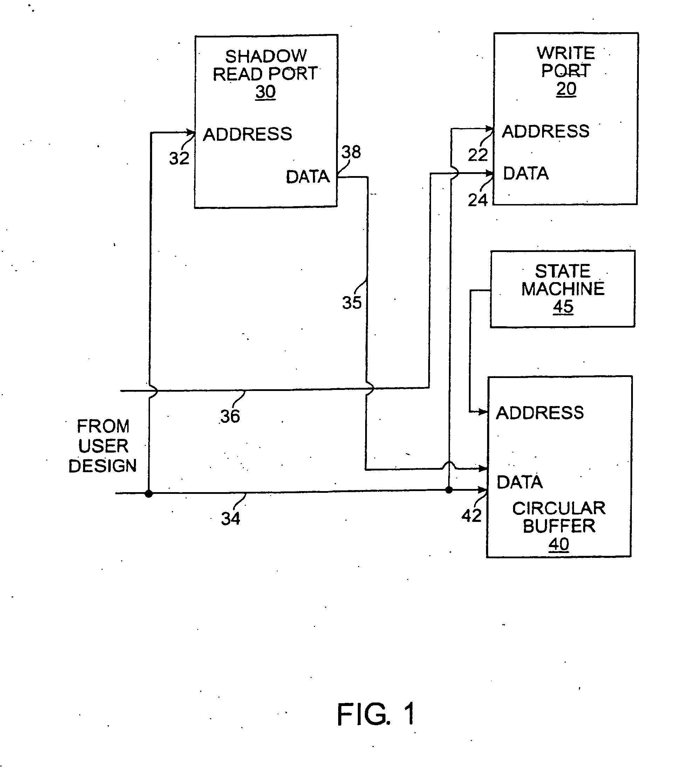

A representative manner in which memory write operations are captured will now be discussed with reference to Fig. 1. As discussed above, almost every DUV will contain a memory circuit 20. Typical memory circuits 20 are arranged so as to have a plurality of memory locations (not shown). Each memory location has an address that can store a certain number of bits of information. Memory circuits are typically classified by the number of memory locations (often referred to as the "depth" of the memory circuit) and the number of bits that can be stored in each location (often referred to as the "width" of the memory circuit). Therefore, a memory circuit having thirty-two thousand locations with each location capable of storing eight bits of information (data) is called a "thirty-two thousand by eight" (i.e., 32Kx8) memory circuit. When the memory circuit has multiple ports, the memory circuit is further defined by the number of write ports and the number of read ports. In a typical multi-port memory implemented in a DUV, data can be written to memory locations through multiple write ports and read from memory locations through multiple read ports.

In order to capture memory write operations according to a first embodiment of the present teachings, the netlist of the DUV is modified. For every write port 20 in each memory in the DUV, a shadow read port 30 is created and inserted into the DUV. Creation of shadow read ports 30 and insertion into the DUV preferably takes place during compilation, although these operations can take place at other times. Shadow read port 30 comprises an address input 32 and a data output 38. Write port 20 comprises a data input 24 that will receive the data to be written into the memory of the DUV and an address input 22 that will point to the particular memory location that the data will be written to. Address data is provided to the address port 22 by an address net 34. Write data is provided to data input 24 by net 36.

In addition, a circular buffer 40 is used. Circular buffer 40 will preferably be a separate memory chip such as a dynamic random access memory (DRAM), although a processor module or FPGA having on-chip memory could be designed such that circular buffers were contained thereon. In a processor-based emulator, each memory write operation in the DUV will be captured at every step in the execution cycle through shadow read ports 30. An execution cycle occurs in the presently preferred processor-based emulator as follows. During emulation, a sequencer on each module (e.g., integrated circuit) that contains the processors increments through a programmed number of steps and may repeat, until halted by the emulation support facilities. Each revolution of the sequencer corresponds to a single clock cycle of the emulated design. The sequencer effectively divides the emulated path clock cycle into multiple (e.g., 256) steps, in which each step corresponds to the evaluation of one logic gate of the emulated design. In FPGA-based emulators, there is no execution.

In contrast to processor based systems, FPGA based systems do not utilize a single central clock which can be used for defining an execution cycle. FPGA systems can usually accept a set of clocks that are asynchronous, which means that each clock can generally not be derived from another clock. In some FPGA systems, it is not even possible to know which signals are the clock signals. Any input signal can serve as a clock.

As also seen in Fig. 1, the DUV is modified such that address net 34, which is present in the DUV and normally communicates with the address port 22 of the memory in the DUV, is also placed in communication with address port 32 on the shadow read port 30 and a data input 42 on circular buffer 40. Likewise, the data pin 38 on the shadow read port 30 outputs data read from the memory to data net 35, which is then input to circular buffer 40. As will be described below, circular buffer 40 is used for memory rewind (reconstruction). These modifications are such that address net 34 and data net 35 must be brought (moved or transferred) off chip and routed to circular buffer 40, which is preferably a separate memory chip.

Note that memory access in the DUV is preferably deterministic. Thus, while the emulator is running the DUV thereon, each read operation of the shadow read port 30 is scheduled to be performed before the memory's write operation via its corresponding write port 24. The reason for this is that when the DUV is writing data into an address in the memory 20, the shadow read port 30 of that memory 20 is set to "read" that address before the write operation occurs. The result of this shadow read operation is stored in circular buffer 40 (i.e., both the data stored in that address and the address itself are stored). The result of the read operation is stored in the circular buffer 40. Thus, the circular buffer 40 will hold the contents of the memory in the user's design (the data stored for each memory location along with its address). Note that this method functions properly because the write address net 34 and output pin 38 on the shadow read port 30 write this information into the circular buffer 40 synchronously.

As seen in Fig. 1, circular buffer 40 has an address pin. When the concepts described herein are implemented in a processor based emulation system, the address pin on circular buffer 40 is in communication with a state machine 45, which controls the addressing of the data stored therein. This state machine 45 increments the address (i.e., the locations were the data stored for each memory location along with its address from the memory 20 in the DUV) every execution cycle. When in rewind mode, which is further described below with respect to Figs 1-3, the state machine 45 decrements the address every execution cycle.

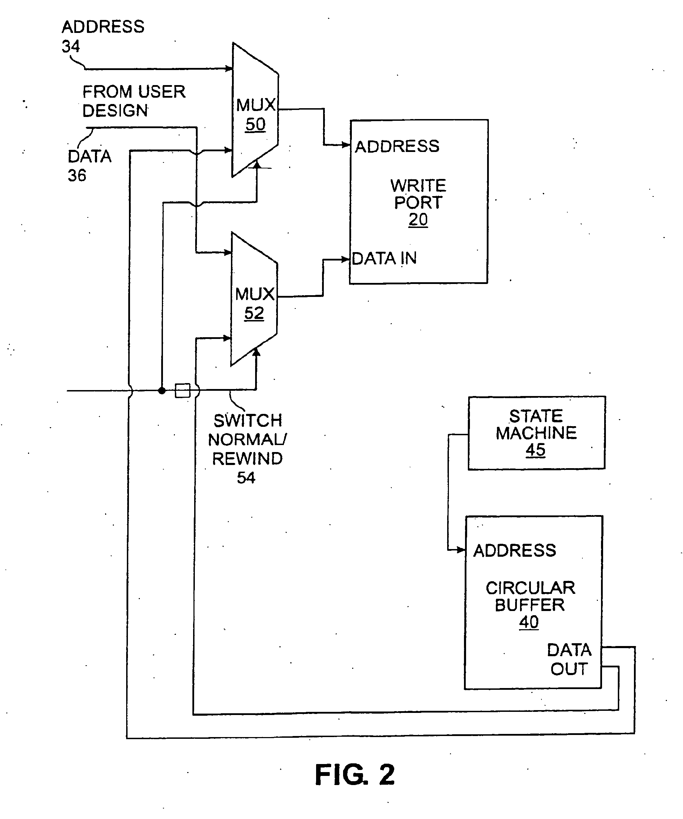

Rewind or reconstruction mode will now be discussed with reference to Fig. 2. Rewind is performed after the initial design execution reaches user defined (i.e., programmable or selectable) checkpoints. Rewind comprises playing back every memory write operation captured during the trace window. Of course, in some embodiments, only a selected number of write operations need to be played back. In order to enable the rewind function, the presently preferred embodiments utilize additional rewind logic that is added to the DUV. Similar to the shadow read ports 30, the presently preferred embodiments insert this rewind logic into the DUV, preferably during compilation.

In addition to inserting shadow read ports 30 into the DUV, rewind logic is inserted into the DUV, preferably at compile time. Rewind logic is preferably comprised of first multiplexer 50 and second multiplexer 52. First multiplexer 50 is preferably a two-input multiplexer with a first input being a data output from circular buffer 40 and a second input being the address signal from the DUV. The select input 54 for the first multiplexer 50 is a signal that is set either for normal emulation mode or for rewind mode. Second multiplexer 52 is also preferably a two-input multiplexer with a first input being a data output from the circular buffer and a second input being a data signal from the DUV. The select input 54 is the same as the first multiplexer 50, namely a signal that selects between normal emulation mode and rewind mode. When the emulator is operating in emulation mode, the first multiplexer 50 and the second multiplexer 52 receive a signal on their select inputs that selects the address and design signals from the DUV, which means that the memory 20 operates according to the circuit arrangement shown in Fig. 1. In contrast, when the emulator is operating in rewind mode, the first multiplexer 50 and second multiplexer 52 receive a signal on their select inputs that selects the address and design signals from the circular buffer 40. At approximately the same time this rewind signal is presented on the select inputs of first multiplexer 50 and second multiplexer 52, the clock that drives the circular buffer 40 begins to decrement. As a result, the data and address information stored in the circular buffer 40 is output to the corresponding data input on the first multiplexer 50 and the corresponding address input on the second multiplexer 52.

Referring to both Fig. 1 and Fig. 2, the operation of a memory in a DUV will now be discussed. During a trace window, the DUV is exercised by external signals such as signals from a target system, test vectors, simulation stimulus, etc, along with one or more clock signals. (Herein, the term "exercise" is intended to mean applying external signals to the DUV while it is running in the verification system.) When the design being emulated attempts to write data into a memory through the first write port 20, the data (e.g., word to be stored) is input to the memory on data net 36 while the address for that word will be input to the memory on address net 34. The data signal passes through data net 36 to the second input on multiplexer 52 and the address passes through address net 34 to the second input on multiplexer 50. Note that during the trace window, the select input 54 for multiplexers 50 and 52 are set such that the first multiplexer 50 and second multiplexer 52 select the inputs from the user design.

To allow for memory rewind, a shadow read operation is scheduled prior to every write operation. The shadow read operation utilizes the shadow read port 30 and involves the same address that will be written using write port 20. Thus, the address being transmitted to write port 20 is also input to shadow read port 30. By sending this address to the shadow read port 30, the data stored in that address is output through data output 38 of shadow read port 30 to circular buffer 40. In the memory rewind embodiments, the address and data are stored in the circular buffer 40 in a last in, first out ("LIFO") arrangement, which allows the user to decrement the state of the memory in the DUV on a step by step basis (a step being a part of an execution cycle), until the beginning of the trace window is reached. As discussed above, a state machine 45 in communication with the address pin on the circular buffer 40 controls this decrementing operation.

Immediately after the shadow read operation takes place for a particular memory address, the write operation for that same memory address will take place. However, because the previous value stored at that memory address is now stored in the circular buffer 40, the previously stored value is available for restoration at a later time. During a write operation, the memory address from address net 34 passes through multiplexer 50 and into the address input for the write port 20. Likewise, the data to be written into that address passes from net 36, through multiplexer 52 and into write port 20, which writes that data into the selected address of the memory.

The emulator will generally switch to the rewind mode from the normal emulation mode when a checkpoint is hit. Such checkpoints can be a trigger, a collection of events, a specific point in time that the user selects, or some other condition. To switch to rewind mode, the select input 54 on first multiplexer 50 and second multiplexer 52 is set such that the memory address and the data stored at that address are passed through multiplexers 50 and 52, respectively, and through write port 20. Once the select signal is switched to rewind, the emulator will operate in rewind mode. When operating in rewind mode, the state machine 45, which is communicating with the address pin on the circular buffer 40, begins to decrement. This decrementing operation allows the contents of the memory in the DUV to be restored, decrement by decrement, until a desired point is reached. Note that the contents of the memory can only be rewound as far back to their state at the beginning of the trace window. This is because the circular buffer 40 will not have stored memory contents that were stored outside of the trace window. The value of the select input 54 is chosen such that the select input 54 on first multiplexer 50 and second multiplexer 52 causes the memory address and the data stored at that address in circular buffer 40 to be passed through multiplexers 50 and 52 in replay mode. As a result, write port 20 writes the data stored in circular buffer 40 at the appropriate address. Because the circular buffer 40 has a LIFO arrangement, the user can rewind the state of the memory, step by step within an execution cycle, thereby decrementing the state of the design in the reverse order in which the design ran through the trace window.

The emulator enters replay mode after the full design contents (i.e., data stored in the memories, data stored in state devices and the values of the primary inputs of the DUV) are restored to the values that the full design contents had at the target execution cycle. The target execution cycle is that point in time in the emulation of a design that the user needs visibility of memory states in order to debug the circuit design. This target execution cycle can be many things, for example, a specific point in time or a specific state of the memory. The manner in which the contents of state devices and values of primary inputs are restored is well known in the art, such that a detailed description herein is not necessary.

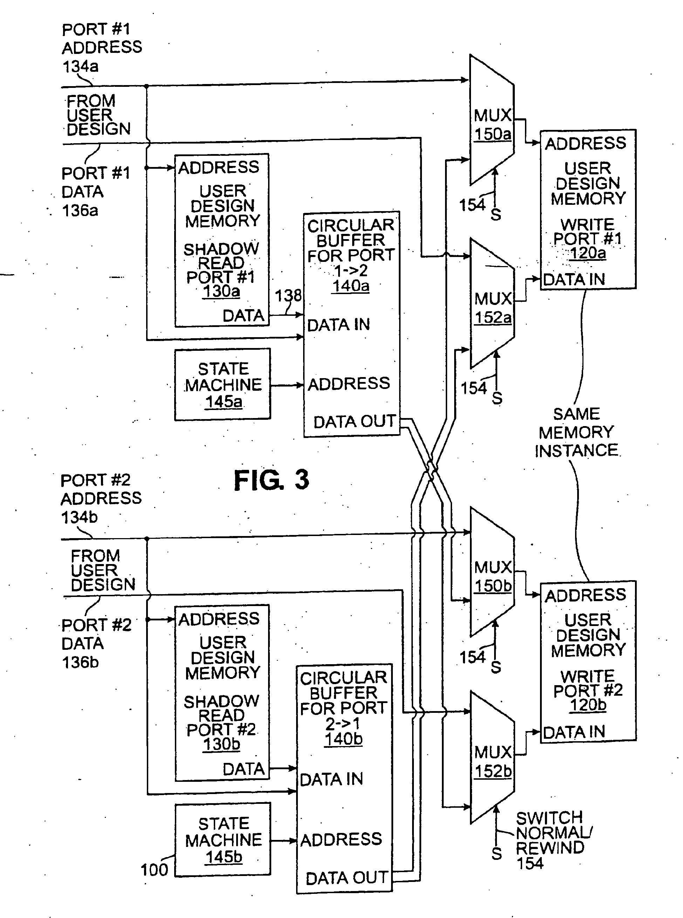

The manner in which the multiport memories are arranged using the concepts disclosed herein will be described with reference to Fig. 3. As discussed, the first embodiment shown in Figs. 1 and 2 modifies the DUV by inserting a shadow read port 30 into the DUV for each write port 20. In a multiport memory containing more than one write port, more than one shadow read port will be inserted. In other words, in the first preferred embodiment shown in Figs. 1 and 2, there will be one shadow read port for each write port in the memory of the user's design. As was also disclosed above, rewind logic may be inserted into the DUV and preferably comprises multiplexers that feed the address and data inputs to the write ports.

The logic diagram of Fig. 3 shows an exemplary embodiment of a memory 100 from a DUV having two write ports. The example of Fig. 3 is only a representative example, as the various embodiments of the present invention are applicable to memories having more than two write ports. First write port 120a has an address input and a data input. The address input on first write port 120a is the output of multiplexer 150a. The data input on first write port 120a is the output of multiplexer 152a. As in the embodiments described above, multiplexer 150a preferably has two inputs, the first being a net carrying the write address for the first write port in the memory in the DUV. The second input to multiplexer 150a is an address stored in second circular buffer 140b. The reason for placing the address output from second circular buffer 140b on the input of multiplexer 152a will be discussed below. Multiplexer 152a preferably has two inputs. The first input to multiplexer 152a is a net carrying the data to be stored in the memory of the DUV. The second input to multiplexer 152a is data stored in second circular buffer 140b. The reason for placing the data that is output from second circular buffer 140b on the input of multiplexer 152a will be discussed below. Multiplexers 150a and 152a have as their select inputs a "switch" that selects between normal emulation mode and rewind mode. Multiplexers 150a and 152a are preferably inserted at compile time. Likewise, first shadow read port 130a is inserted into the DUV, preferably at compile time. An input to first shadow read port 130a is the net 134b carrying the write address for the first write port 120a in the memory of the DUV. The output of first shadow read port 130a is input to a data input of first circular buffer 140a. First circular buffer 140a has an input that receives an output from first state machine 145a. As discussed above, first state machine 145a addresses the memory locations within first circular buffer 140a during rewind. As was discussed above, the output of the first shadow read port 130a is the data that is stored at the memory address, along with that memory address.

The address input on second write port 120b is the output of multiplexer 150b. The data input on second write port 120b is the output of multiplexer 152b. As in the embodiments described above, multiplexer 150b has two inputs, the first being a net carrying the write address for the second write port in the memory in the DUV. The second input to multiplexer 150b is an address stored in first circular buffer 140a. The reason for placing the address output from first circular buffer 140a on the input of multiplexer 152b will be discussed below. Multiplexer 152b also has two inputs. The first input to multiplexer 152b is a net carrying the data to be stored in the memory of the DUV. The second input to multiplexer 152b is data stored in first circular buffer 140a. The reason for placing the data that is output from first circular buffer 140a on the input of multiplexer 152b will be discussed below. Multiplexers 150b and 152b have as their select inputs a "switch" that selects between normal mode and rewind mode. Multiplexers 150b and 152b are preferably inserted at compile time. Likewise, second shadow read port 130b is inserted into the DUV, preferably at compile time. An input to second shadow read port 130b is the net carrying the write address for the second write port in the memory of the DUV. The output of second shadow read port 130b is the data that is stored at the memory address, along with that memory address.

For memories with multiple write ports as in the example of Fig. 3, every write port (e.g., write ports 120a and 120b) is fed with data from a shadow read port corresponding to another write port that will be referred to as a mirror write port. In the example shown in Fig. 3, first circular buffer 140a captures data from first shadow read port 130a that was inserted into the DUV for the first write port of the memory in the DUV. Likewise, second circular buffer 140b captures data from second shadow read port 130b that was inserted into the DUV for the second write port of the memory in the DUV. Second circular buffer 140b has an input that receives an output from a second state machine 145b. As discussed above, second state machine 145b addresses the memory locations within second circular buffer 140b during rewind. During memory rewind, first circular buffer 140a feeds the same memory instance (e.g., memory address along with the data stored at that address) through second write port 120b. Thus, in this example, during rewind, second write port 120b functions as the mirror write port for first write port 120a. Likewise, first write port 120a functions as the mirror write port for second write port 120b.

The reason for using mirrored write ports will now be discussed. During a trace window, the DUV is exercised by external signals such as signals from a target system, test vectors, simulation stimulus, etc. When the design being emulated attempts to write data into a memory through the first write port 120a, the data (e.g., word or information to be stored) is input to the memory on data net 136a and the address for that word will be input to the memory on address net 134a. During the trace window, the select inputs 154 of multiplexers 150a and 152a are set such that the address and data for that address are passed therethrough and into the first write port 120a. To allow for memory rewind, a shadow read operation is scheduled prior to every write operation. The shadow read operation utilizes the first shadow read port 130a and involves the same address that will be written using first write port 120a. Thus, the address being transmitted to first write port 120a is also input to first shadow read port 130a. By sending this address to the first shadow read port 130a, the data stored in that address in the DUV is output through data output 138 of first shadow read port 130a to first circular buffer 140a.

Immediately after the shadow read operation takes place for a particular memory address, the write operation for that same memory address will take place. However, because the previous value stored at that memory address is already stored in the first circular buffer 140a, the previously stored value is available for restoration at a later time. During a write operation, the memory address from address net 134a passes through multiplexer 150a and into the address input for the first write port 120a. Likewise, the data to be written into that address passes from net 136a, through multiplexer 152a and into first write port 120a, which writes that data into the selected address of the memory.

As discussed, when the emulator switches to rewind mode, the select input 154 on first multiplexer 150a and second multiplexer 152a is set such that the memory address and the data stored at that address, which are stored in the first circular buffer 140a, are passed through multiplexers 150b and 152b, respectively, and through second write port 120b. Second write port 120b then writes this data at the proper address. In other words, when rewinding or reconstructing the data stored in the memory, the second write port 120b functions as the mirror write port for the first write port 120a. The reason for using mirror write ports is as follows. When the emulator is running through a trace window, data is being written to locations within the memory. During each write operation, the data stored at these locations is read from the memory in the DUV by the shadow read port and stored in the circular buffers 140a, 140b, as well as the address. When the memory enters rewind, the execution cycle will be played backwards, which means that data to be stored at a particular address must be written through its mirror write port.

If the mirror write port were not used, the memory writes in a processor based emulation system would be deterministically wrong. For example, assume that at some cycle, both ports of a two write port memory write to the same address A. Further assume that port one writes data D1 followed by the port two writing data D2. Also assume that data at address A before both of these write operations was D. Shadow read port one will store data D for address A; then shadow read port two will store data D1 for this same address A. If during rewind the write ports are not mirrored, then port one will write data D followed by port two writing data D1. After these two write operations, address A will store wrong value D1 instead of correct initial value D. On the hand, if ports are mirrored, then during rewind port one writes data captured via shadow read port two, which is D1, followed by port two writing data captured via shadow port one, namely D. Hence, correct initial data D is stored at address A after both writes.

Note that mirroring of write ports is set up during design compilation according to their scheduling within a single execution cycle. For a write port that is scheduled to write at the Nth step counting forward from the beginning of execution cycle, its mirror write port to be scheduled to write at the Nth step counting backward from the end of execution cycle.

Note that the multiport memory shown in Fig. 3 is merely an example. Many more ports, including an odd number of ports, can be utilized. For example, in a multiport memory having five ports (i.e., port one, port two, port three, port four and port five), port five would function as the mirror write port for port one (and vise versa), port four would function as the mirror write port for port two (and vise versa) and port three would function as the mirror write port for itself.

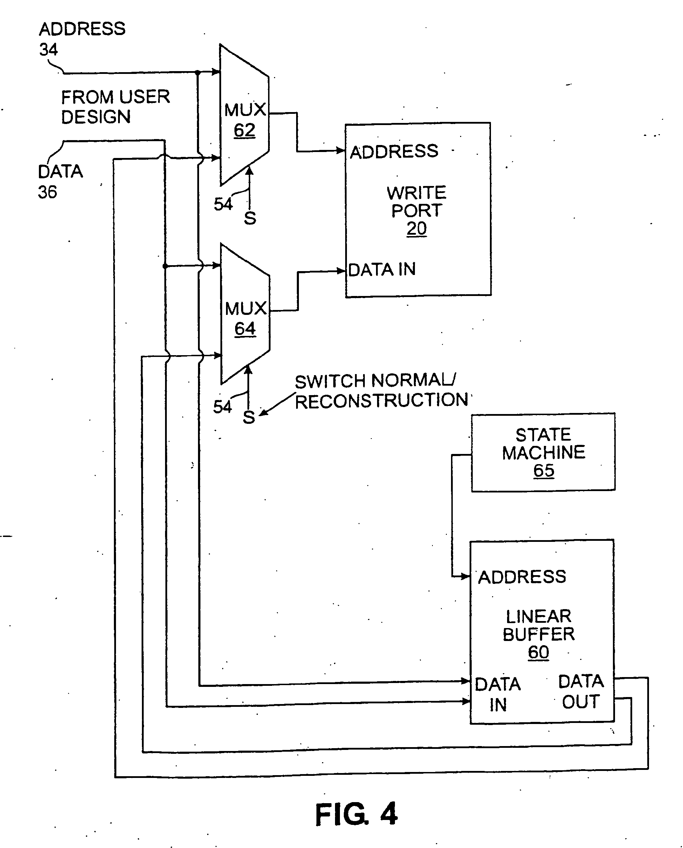

A representative method for restoring the contents of a memory in a DUV will now be discussed with reference to Fig. 4. In this embodiment, the data and address values for each write port are recorded directly from the beginning of emulation or simulation time (time zero) during the capture stage. Data can be captured either every main clock cycle, or only when there is a write request to the memory in order to reduce the amount of recorded data. In the case where data is only captured when there is a write request, the data can be organized in blocks so that only the time for the beginning of each block needs to be known during the restore stage.

In this particular embodiment, shadow read ports are not used. The DUV is, however, modified by insertion of additional logic. In this embodiment, the DUV is modified by insertion of a first multiplexer 62 and a second multiplexer 64. First multiplexer 62 is preferably a two input multiplexer, the output of which feeds the address input to write port 20. Second multiplexer 64 is preferably a two input multiplexer, the output of which feeds the data input of write port 20. First input to first multiplexer 62 is the address net 34 from the DUV (i.e., the user's design). First input to second multiplexer 64 is the data net 36 from the DUV. In this embodiment, a memory circuit (e.g., a memory chip) is installed in the emulator, which memory circuit functions as a linear buffer 60. Linear buffer 60 receives address data from address net 34 and the data to be stored in that address from data net 36. Linear buffer 60 has a first output that transmits memory addresses to a second input on first multiplexer 62. Linear buffer 60 also has a second output that outputs the data for a particular memory address to a second input on second multiplexer 64. First multiplexer 62 and second multiplexer 64 both have a select input for receiving a signal (S) that selects between normal emulation mode and reconstruction mode.

To enter or switch to the memory restore or reconstruct stage, the select input 54 to first multiplexer 62 and second input 64 are switched to reconstruction mode. This switch causes the first multiplexer 62 and second multiplexer 64 to output data that is input from (i.e., provided by) the linear buffer 60. Linear buffer 60 is preferably arranged in a FIFO arrangement, which means that the write operations are replayed from time zero of the trace window up to the point in time that the user wants to restore. Thus, unlike the circular buffer 40 described above, the state machine 65 that drives linear buffer 60 does not need to decrement. The state machine 65 is preferably synchronized with the clock that drives the DUV. In this case, the linear buffer 60 increments its own memory locations synchronously with the write operations in the memory 20 in the DUV. Note that the memory chip (or on-chip memory, if this arrangement is used) must be large enough to capture all of the data generated by the memories from time zero of the trace window. Because this method requires large amounts of memory, part of the linear buffer 60 may reside inside the emulator, while another part of the linear buffer 60 may reside in the workstation that controls the emulator.

A variation of the embodiment described with reference to Fig. 4 is to periodically store the contents of the entire memory in the DUV (akin to taking a "snapshot" of the entire contents of the memory). The time period for taking this snapshot is preferably a very large period (e.g. hundreds of thousands or millions of cycles apart). In this embodiment, the restore process would first restore the memory contents from the latest saved snapshot into the memory of the DUV. The snapshot that would be restored is preferably the snapshot taken immediately prior to the point in time that user wants to restore. After restoring the memory contents with the snapshot, the DUV replays the write operations using the method described above from the snapshot time. The advantage of this embodiment is that it does not require the linear buffer 60 to store the entire history of write operations from time zero of the trace window. Thus, a smaller linear buffer 60 can be used.

The same concepts discussed above are applicable to implementing the methods disclosed herein for FPGA-based emulation systems. There are some differences in implementation, which will now be discussed. Most of the differences in implementation are due to the fact that in FPGA based systems, there is no single central clock which can be used for defining a basic cycle similar to the clock that is present in processor based systems. FPGA systems can usually accept a set of clocks that are asynchronous (i.e. one clock cannot be derived from another). On the other hand, processor based emulators, while being able to emulate designs with asynchronous clocks, operate synchronously internally. In fact, in some FPGA systems, the system may not even know which signals input to the emulator are clock signals. Any input signal can serve as a clock.

The order in which write operations in multi-port memories takes place in an FPGA based system is also an issue because the write order between two write ports that happen simultaneously might be determined by a miniscule time difference between the two write requests. Since write requests are not timed by a central clock, more elaborate mechanisms have to be built to handle the write ordering between different write ports.

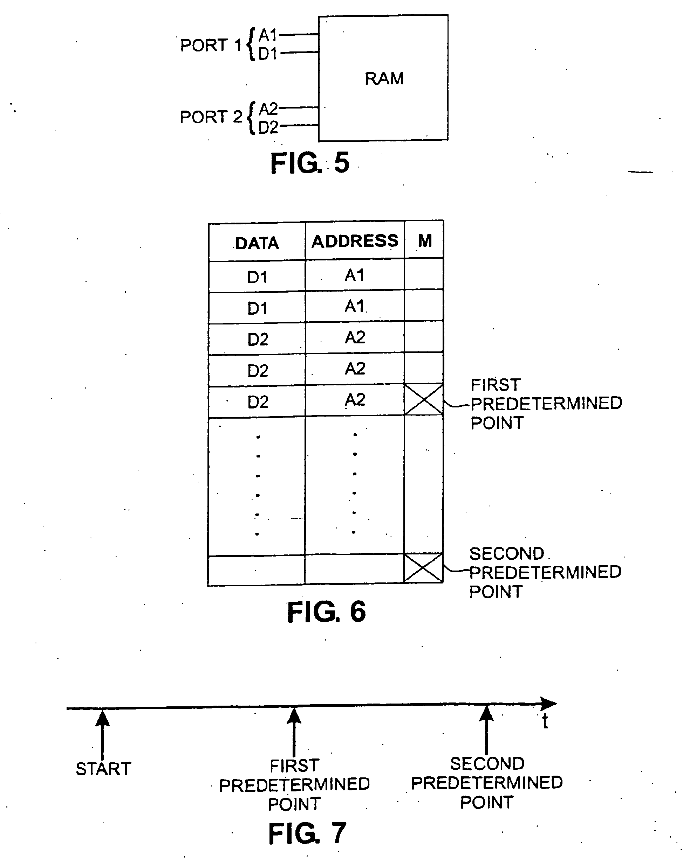

There are at least two methods for implementing the concepts disclosed herein in FPGA based systems. A first method, which will be described with reference to Figs. 5-7, relies on "event driven" methodologies. Fig. 5 shows a multiport memory having two write ports. Write port one is comprised of an address input A1 and a data input D1. Write port two is comprised of an address input A2 and a data input D2. FPGA based systems do not provide a basic clock that defines a cycle (i.e., there is no execution cycle like that discussed above). Instead, snapshots of the contents of the entire state of the DUV, except for the data stored in the RAMs in the DUV, are stored in circular buffer (Fig. 6) at specific predetermined points during emulation. This concept of specific predetermined points is illustrated in Fig. 7, which shows a timeline having an emulation start, a first predetermined point and a second predetermined point. During emulation, each write operation is stored simultaneously in the RAM of the DUV and in the circular buffer. Note that in some embodiments, data from write operations are stored in a different circular buffer than other contents of the state of the DUV. Like in the processor based implementation, shadow read ports can be used for this operation, although other implementations are possible as well. After each write to the circular buffer, the circular buffer address is advanced by one. At each predetermined point, a marker is written into the circular buffer, thereby indicating that the write operation stored at this location in the circular buffer corresponds to a predetermined point. This use of markers (M) is shown in Fig. 6. Note that predetermined points are preferably set (programmable) by the user of the verification system.

When data is written through different write ports to the same memory location, the data is stored one after the other in the circular buffer in the same order in which the data are written into the memory location. In other words, data from different write ports will be written one after the other into the circular buffer according to the order in which the data were written into the memory location of the RAM in the DUV. Thus, during rewind, there is no need to know which write port wrote the data into the particular memory location, because the data written into the DUV was stored in the circular buffer in the correct order. This means that the rewind phase needs only one write port to write the data into the RAM of the DUV that is being emulated.

Note that this implementation makes it unnecessary to utilize mirror write ports. The reason for this is that, unlike processor based systems, correct ordering of data written from the circular buffer need not be achieved during rewind by reconnecting the ports in the reverse order (i.e., through mirroring of the write ports). In this embodiment, the temporal ordering of the write operations stored in the circular buffer can be relied upon to achieve the correct ordering. This correct ordering is achieved, because data stored in the circular buffers will be written into the RAM through only one write port, regardless of how many write ports the RAM in the DUV actually has. Note that if a similar structure is used in a processor based system, mirroring of write ports will not be necessary in processor based systems. It should be noted that this embodiment can also be implemented in a processor based system, which eliminates the need to use mirror write ports when using processor based verification systems.

In this method, the number of addresses that are written into the circular buffer depends on the number of write operations (which varies depending on what functions the DUV is performing). This variation requires that each memory instance has its own circular buffer, so the memory instance can advance independently of circular buffers of other memory instances.

An alternative embodiment will now be discussed in which a basic clock is generated internally by the system. This basic clock must be fast enough (e.g., have a high enough frequency) to sample any net without missing any transition of the fastest clock in the system. In other words, the frequency of this basic clock must be set high enough so that no signals in the DUV will change more than once during one cycle of the basic clock. Since the user of the verification system should know the DUV well enough, the user should select the frequency of the basic clock. The basic clock can be used to define "cycles", thereby making each cycle of the basic clock analogous to the execution cycle of the processor based system. During each such cycle of the basic clock, no more than a single write operation can be executed for each write port of any memory. Thus, write operations are stored the same way as in processor based systems. The remaining processes steps are substantially the same as for processor based systems and thus need not be further discussed herein.

As long as each memory in the DUV has no more than one write port, the methods described above with respect to processor based systems can be used. However, when memories in the DUV have multiple write ports, a different approach is preferably utilized. A problem arises when two or more write ports are used to write data into the memory in the DUV during the same cycle of the basic clock. As discussed above, if the write order through the various write ports is not maintained, the memory reconstruction will not be accurate.

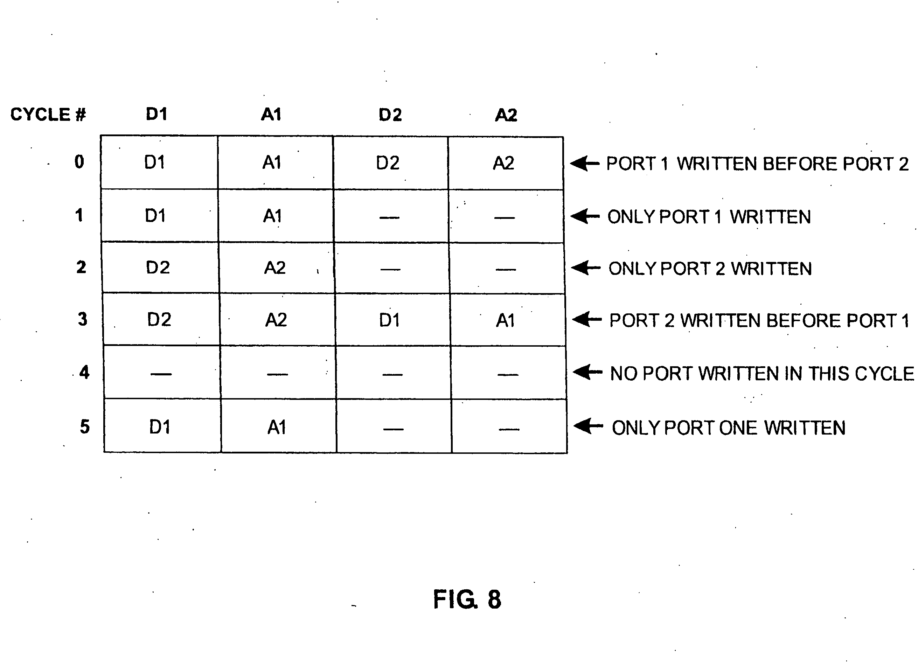

In another variation, a special circuit is added to the steering logic of the memory instance, which special circuit monitors the write operations and determines the actual write order from the different write ports. The special circuit then records the data in such a way that the reconstruction stage can replay the data in the exact reverse order within each cycle. This embodiment relies on the temporal ordering of the write operations in the reconstruction stage to achieve the desired effect of writing the data for the different write ports in the correct order. Figure 8 is a table showing an example of how the system can keep track of the temporal ordering of the write operations. Because of this, the reconstruction stage can actually write back all the data from the circular buffer into the memory instance through a single write port, because the order is determined by correctly sequencing the data in the time domain. Again, this construction eliminates the need for mirror ports.

Fig. 8 shows the memory write operations for a two port memory. The first two columns show the first write operation for a given cycle while the second two columns show the second write operation for a given cycle. Turning to the example shown in Fig. 8, in the first cycle, which is the first row, port 1 is written before port 2. In the second cycle, only port 1 has a write operation. In the third cycle, port 1 undergoes a write operation. In the fourth cycle, port 2 has a write operation before port 1. In the fifth cycle, neither port 1 nor port 2 undergoes a write operation. In the final cycle, only port 1 undergoes a write operation.

In many cases, emulation systems can implement a memory with multiple write ports (which will be called herein a "logic memory cell") by using a "wrapper" method. The wrapper method uses a simpler memory structure (which will be called herein the "physical memory cell") with fewer write ports (typically only a single write port) 200. A logic circuit that multiplexes the write ports to the logic memory cell 200 using time domain multiplexing is used. Therefore, during a single clock cycle of the design, the logic memory cells write ports are multiplexed using a higher frequency clock. As a result, each write port may write to the physical memory cell using a different time slot. When such wrapper method is used, any of the methods for rewinding and reconstructing memory contents described herein can be applied either to the write ports of the logic memory cell or to the write ports of the physical memory cell.

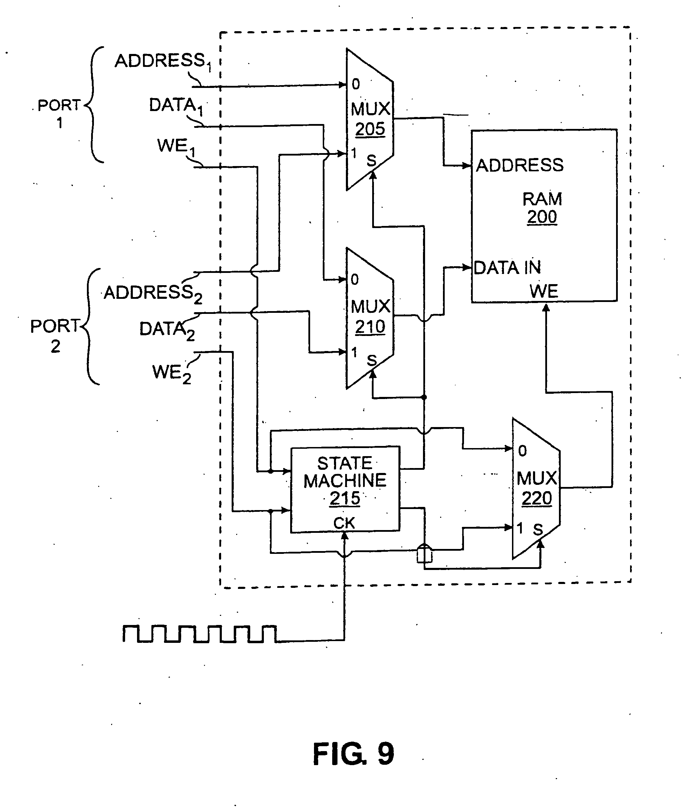

A representative wrapper method will be explained with reference to Fig. 9. Memory cell 200 is a single port memory with an address input A, a data input D and a write enable input WE. To convert this memory cell 200 into a dual port memory, additional circuitry is added. A multiplexer 205 feeds the address input to the memory 200. A multiplexer 210 feeds the data input to the memory cell 200. Multiplexer 205 has a first input from the address input A1 of port 1 and a second input from the address input A2 of port 2. Multiplexer 210 has a first input from the data input D1 from port 1 and a second input from the data input D2 from port 2. A state machine 215 has a first input from write enable WE1 from port 1 and a second input from write enable WE2 from port 2. State machine 215 has a clock input that receives a fast clock signal, which preferably has a frequency much faster than the frequency at which the emulator runs. State machine 215 has a first output that drives the select inputs of multiplexers 205 and 210. State machine 215 has a second output that drives the select input of a multiplexer 220. Write enable WE1 from port 1 drives a first input on multiplexer 220 while write enable WE2 from port 2 drives a second input on multiplexer 220.

The various embodiments described herein have been discussed in terms of utilizing the hardware of the emulator to perform memory restore or reconstruction. The various embodiments disclosed herein, however, can also be performed by software on a workstation instead of inside the emulator hardware. The manner in which software is used to perform memory restoration is as follows. When the reconstructed memory will be written to a verification system other than the emulator on which the DUV was originally run, the contents of the memory in the DUV, together with the data that was recorded from the write operations during the capture stage, are transferred to the workstation that controls the emulator. A software program will then reconstruct the contents of the memory using the method as described above, and transfer the contents of the reconstructed memory to the alternate verification system. Alternative logic verification systems, such as software simulators, allow the memory operations of the DUV to be analyzed using the simulator. When the reconstructed memory will be written back into the same emulator which was originally running the DUV, the contents of the RAM do not need to be read into the workstation. The contents of the buffer (trace or linear) are transferred into the workstation, where the memory is reconstructed. After reconstruction, the workstation transfers only those addresses that have been changed back into the emulator. Note that if this method is utilized, the addresses must be tracked so that the addresses that were written are known, which prevents writing data into incorrect addresses. Regardless of whether the reconstructed memory is transferred to an emulator or another verification system, such as another emulator or a software simulator, this reconstruction process can be performed either on the entire contents of the memory, or only on parts of the memory that were affected by the write operations during the capture stage (i.e., the trace window). By selectively performing reconstruction on only those parts of the memory in the DUV that were affected by the write operation during the trace window, the amount of data that needs to be transferred back and forth between the emulator and the workstation is significantly reduced. In addition, less manipulation of the netlist may be necessary because, for example, multiplexers (e.g., multiplexers 50, 52) will not be needed at the inputs to the write ports.

Also note that the methods described herein can also be used in other systems for simulating designs such as simulation acceleration engines, which use specialized hardware, or software simulators. Some modifications may be necessary, however. For example, in a software simulator, multiplexers would not be necessary for selection between original design write operations and restoration write operations (i.e., writing data from the circular or linear buffers). In addition, when restoring the contents of the memories in a software simulator, the memory restore method can be executed by a separate program that is not part of the simulator.

Thus, the various embodiments disclosed herein can be used for either simulating or emulating a digital design. In addition, the various embodiments disclosed herein are useful when emulating a design using test vectors or when the emulator is operating with a target system (i.e., during circuit emulation).

The various embodiments disclosed herein may take the form of a computer program comprising a series of instructions. These instructions may be supplied on computer usable media. Common forms of computer-usable media include, for example: a floppy disk, flexible disk, hard disk, magnetic tape, any other magnetic medium, CD-ROM, any other optical medium, punchcards, papertape, any other physical medium with patterns of holes, RAM, ROM, PROM (i.e., programmable read only memory), EPROM (i.e., erasable programmable read only memory), including FLASH-EPROM, any other memory chip or cartridge, carrier waves, or any other medium.

Thus, various embodiments of the present invention have been described with reference to specific embodiments. It will, however, be evident that various modifications and changes may be made thereto without departing from the scope of the invention. For example, the skilled person will readily understand that the specific ordering and combination of process actions shown in the process flow diagrams described herein is merely illustrative, and the invention can be performed using different or additional process actions, or a different combination or ordering of process actions. The specification and drawings are, accordingly, to be regarded in an illustrative rather than restrictive sense, and the invention is not to be restricted or limited except in accordance with the following claims and their legal equivalents. Moreover, the various features of the preferred embodiments and the dependent claims may be combined in ways that are not specifically and explicitly enumerated in order to provide additional useful embodiments of the present teachings. In addition, it is expressly noted that all features disclosed in the description and/or the claims are intended to be disclosed separately and independently from each other for the purpose of original disclosure, as well as for the purpose of restricting the claimed subject matter independent of the compositions of the features in the embodiments and/or the claims.

## Claims

1. A method for verifying the operation of a circuit design comprising at least one random access memory (RAM) having at least one write port (20; 120a, 120b) and a plurality of memory locations, the method comprising exercising the circuit design in a functional verification system,
**characterized by**:
reading data stored at a selected one of said plurality of memory locations in said RAM immediately prior to writing new data in said selected one of said plurality of memory locations in said RAMH;
storing said read data in at least one buffer (40; 60; 140a, 140b);
at a checkpoint, reading said data stored in said at least one buffer; and
as said data is read from said at least one buffer, writing said data into said RAM.

2. The method of claim 1 wherein the functional verification system comprises a logic verification system, such as a processor based emulation system or a field programmable gate array based emulation system, or a software simulator.

3. The method of claim 1 or 2 further comprising:
inserting rewind logic (50, 52; 150a, 150b, 152a, 152b; 62, 64; 205, 210) into the circuit design before exercising the circuit design.

4. The method of any one of claims 1, 2 or 3 further comprising:
modifying the circuit design, before exercising the circuit design, to insert at least one shadow read port (30; 130a, 130b) for the at least one write port (20; 120a, 120b), wherein the shadow read port reads said data before said data is stored in said at least one buffer (40; 140a, 140b).

5. An apparatus for verifying the operation of a circuit design comprising at least one random access memory (RAM) having at least one write port (20; 120a, 120b) and a plurality of memory locations, the apparatus comprising means for exercising the circuit design in a functional verification system,
**characterized by**:
means for reading data stored at a selected one of said plurality of memory locations in said RAM immediately prior to writing new data in said selected one of said plurality of memory locations in said RAM;
means for storing said read data in at least one buffer (40; 60; 140a, 140b); and
means for reading said data stored in said at least one buffer and writing said data into said RAM as said data is read from said at least one buffer.

6. The apparatus of claim 5 wherein the functional verification system comprises a logic verification system, such as a processor based emulation system or a field programmable gate array based emulation system, or a software simulator.

7. The apparatus of claim 5 or 6 further comprising:
means for inserting rewind logic (50, 52; 150a, 150b, 152a, 152b; 62, 64; 205, 210) into the circuit design before exercising the circuit design.

8. The apparatus of any one of claims 5-7 further comprising:
means for modifying the circuit design, before exercising the circuit design, to insert at least one shadow read port (30; 130a, 130b) for the at least one write port (20; 120a, 120b), wherein the shadow read port is adapted to read said data before said data is stored in said at least one buffer (40; 140a, 140b).

9. The apparatus of any one of claims 5-8, wherein the at least one buffer is at least one circular buffer (40; 140a, 140b) and said means for reading said data is adapted to read said data from said at least one circular buffer in a reverse order before writing said data into said RAM.

10. The apparatus of any one of claims 5-9, further comprising a first multiplexer (50; 62; 150a, 150b; 205) adapted to supply to said at least one RAM the address for the data to be stored and a second multiplexer (52; 64; 152a, 152b; 210) adapted to supply to said at least one RAM said data to be stored, wherein the at least one buffer (40; 60; 140a, 140b) is connected to the first and second multiplexers to supply the address and the data stored in the buffer to said at least one RAM.

## Patentansprüche

1. Verfahren zum Verifizieren der Funktion eines Schaltungsentwurfs mit mindestens einem Zufallszugriffsspeicher (RAM), der mindestens einen Schreib-Port (20; 120a, 120b) und eine Mehrzahl von Speicherstellen aufweist, wobei das Verfahren ein Ausführen des Schaltungsentwurfs in einem Funktionalverifizierungssystem beinhaltet,
**gekennzeichnet durch**:
Lesen von Daten, die an einer ausgewählten der Mehrzahl von Speicherstellen in dem RAM gespeichert sind, unmittelbar vor einem Schreiben von neuen Daten an die ausgewählte der Mehrzahl von Speicherstellen in dem RAM;
Speichern der gelesenen Daten in mindestens einem Puffer (40; 60; 140a, 140b);
an einem Kontrollpunkt, Lesen der in dem mindestens einen Puffer gespeicherten Daten; und
während die Daten aus dem mindestens einem Puffer ausgelesen werden, Schreiben der Daten in das RAM.

2. Verfahren nach Anspruch 1, bei dem das Funktionalverifizierungssystem ein Logikverifizierungssystem, beispielsweise ein prozessorbasiertes Emulationssystem oder ein auf einem feldprogrammierbaren Gate-Array basierendes Emulationssystem, oder einen Software-Simulator aufweist.

3. Verfahren nach Anspruch 1 oder 2, ferner beinhaltend:
Einfügen einer Rücksetzlogik (50, 52; 150a, 150b, 152a, 152b; 62, 64; 205, 210) in den Schaltungsentwurf vor einem Ausführen des Schaltungsentwurfs.

4. Verfahren nach einem der Ansprüche 1, 2 oder 3, ferner beinhaltend:
Modifizieren des Schaltungsentwurfs vor einem Ausführen des Schaltungsentwurfs zum Einfügen mindestens eines Shadow-Lese-Ports (30; 130a, 130b) für den mindestens einen Schreib-Port (20; 120a, 120b), wobei der Shadow-Lese-Port die Daten liest, bevor die Daten in dem mindestens einen Puffer (40; 140a, 140b) gespeichert werden.

5. Vorrichtung zum Verifizieren der Funktion eines Schaltungsentwurfs mit mindestens einem Zufallszugriffsspeicher (RAM), der mindestens einen Schreib-Port (20; 120a, 120b) und eine Mehrzahl von Speicherstellen aufweist, wobei die Vorrichtung ein Mittel zum Ausführen des Schaltungsentwurfs in einem Funktionalverifizierungssystem aufweist,
**gekennzeichnet durch**:
ein Mittel zum Lesen von Daten, die an einer ausgewählten der Mehrzahl von Speicherstellen in dem RAM gespeichert sind, unmittelbar vor einem Schreiben von neuen Daten an die ausgewählte der Mehrzahl von Speicherstellen in dem RAM;
ein Mittel zum Speichern der gelesenen Daten in mindestens einem Puffer (40; 60; 140a, 140b); und
ein Mittel zum Lesen der in dem mindestens einen Puffer gespeicherten Daten und Schreiben der Daten in das RAM, während die Daten aus dem mindestens einen Puffer ausgelesen werden.

6. Vorrichtung nach Anspruch 5, bei der das Funktionalverifizierungssystem ein Logikverifizierungssystem, beispielsweise ein prozessorbasiertes Emulationssystem oder ein auf einem feldprogrammierbaren Gate-Array basierendes Emulationssystem, oder einen Software-Simulator aufweist.

7. Vorrichtung nach Anspruch 5 oder 6, ferner mit:
einem Mittel zum Einfügen einer Rücksetzlogik (50, 52; 150a, 150b, 152a, 152b; 62, 64; 205, 210) in den Schaltungsentwurf vor einem Ausführen des Schaltungsentwurfs.

8. Vorrichtung nach einem der Ansprüche 5-7, ferner mit:
einem Mittel zum Modifizieren des Schaltungsentwurfs vor einem Ausführen des Schaltungsentwurfs zum Einfügen mindestens eines Shadow-Lese-Ports (30; 130a, 130b) für den mindestens einen Schreib-Port (20; 120a, 120b), wobei der Shadow-Lese-Port zum Lesen der Daten, bevor die Daten in dem mindestens einem Puffer (40; 140a, 140b) gespeichert werden, angepasst ist.

9. Vorrichtung nach einem der Ansprüche 5-8, bei der das mindestens eine Puffer mindestens ein Zirkularpuffer (40; 140a, 140b) ist und das Mittel zum Lesen der Daten zum Lesen der Daten aus dem mindestens einen Zirkularpuffer in umgekehrter Reihenfolge vor einem Schreiben der Daten in das RAM angepasst ist.

10. Vorrichtung nach einem der Ansprüche 5-9, ferner mit einem ersten Multiplexer (50; 62; 150a, 150b; 205), der zum Zuführen der Adresse der zu speichernden Daten zu dem mindestens einen RAM angepasst ist, und einem zweiten Multiplexer (52; 64; 152a, 152b; 210), der zum Zuführen der zu speichernden Daten zu dem mindestens einen RAM angepasst ist, wobei das mindestens eine Puffer (40; 60; 140a, 140b) zum Zuführen der Adresse und der in dem Puffer gespeicherten Daten zu dem mindestens einem RAM mit dem ersten und dem zweiten Multiplexer verbunden ist.

## Revendications

1. Procédé de vérification du fonctionnement d'une conception de circuit comprenant au moins une mémoire vive (RAM) ayant au moins un port d'écriture (20 ; 120a, 120b) et une pluralité d'emplacements de mémoire, le procédé comprenant l'exécution de la conception de circuit dans un système de vérification fonctionnelle, **caractérisé par** :
la lecture de données stockées à l'un sélectionné de ladite pluralité d'emplacements de mémoire dans ladite RAM immédiatement avant l'écriture de nouvelles données au dit l'un sélectionné de ladite pluralité d'emplacements de mémoire dans ladite RAM ;
le stockage desdites données lues dans au moins une mémoire tampon (40 ; 60 ; 140a, 140b) ;
à un point de contrôle, la lecture desdites données stockées dans ladite au moins une mémoire tampon ; et
au fur et à mesure que lesdites données sont lues de ladite au moins une mémoire tampon, l'écriture desdites données dans ladite RAM.

2. Procédé selon la revendication 1, dans lequel le système de vérification fonctionnelle comprend un système de vérification logique, comme un système d'émulation à base de processeur ou un système d'émulation à base de réseau prédiffusé programmable par l'utilisateur, ou un simulateur logiciel.

3. Procédé selon la revendication 1 ou 2, comprenant en outre :
l'insertion d'une logique de rembobinage (50, 52 ; 150a, 150b, 152a, 152b ; 62, 64 ; 205, 210) dans la conception de circuit avant d'exécuter la conception de circuit.

4. Procédé selon l'une quelconque des revendications 1, 2 et 3, comprenant en outre :
la modification de la conception de circuit, avant d'exécuter la conception de circuit, pour insérer au moins un port de lecture d'ombre (30 ; 130a, 130b) pour l'au moins un port d'écriture (20 ; 120a, 120b), dans lequel le port d'écriture d'ombre lit lesdites données avant que lesdites données ne soient stockées dans ladite au moins une mémoire tampon (40 ; 140a, 140b).

5. Appareil de vérification du fonctionnement d'une conception de circuit comprenant au moins une mémoire vive (RAM) ayant au moins un port d'écriture (20 ; 120a, 120b) et une pluralité d'emplacements de mémoire, l'appareil comprenant un moyen pour l'exécution de la conception de circuit dans un système de vérification fonctionnelle,
**caractérisé par** :
un moyen pour la lecture de données stockées à l'un sélectionné de ladite pluralité d'emplacements de mémoire dans ladite RAM immédiatement avant l'écriture de nouvelles données au dit l'un sélectionné de ladite pluralité d'emplacements de mémoire dans ladite RAM ;
un moyen pour le stockage desdites données lues dans au moins une mémoire tampon (40 ; 60 ; 140a, 140b) ; et
un moyen pour la lecture desdites données stockées dans ladite au moins une mémoire tampon et l'écriture desdites données dans ladite RAM au fur et à mesure que lesdites données sont lues de ladite au moins une mémoire tampon.

6. Appareil selon la revendication 5, dans lequel le système de vérification fonctionnelle comprend un système de vérification logique, comme un système d'émulation à base de processeur ou un système d'émulation à base de réseau prédiffusé programmable par l'utilisateur, ou un simulateur logiciel.

7. Appareil selon la revendication 5 ou 6, comprenant en outre :
un moyen pour l'insertion d'une logique de rembobinage (50, 52 ; 150a, 150b, 152a, 152b ; 62, 64 ; 205, 210) dans la conception de circuit avant d'exécuter la conception de circuit.

8. Procédé selon l'une quelconque des revendications 5 à 7, comprenant en outre :
un moyen pour la modification de la conception de circuit, avant d'exécuter la conception de circuit, pour insérer au moins un port de lecture d'ombre (30 ; 130a, 130b) pour l'au moins un port d'écriture (20 ; 120a, 120b), dans lequel le port d'écriture d'ombre est apte à lire lesdites données avant que lesdites données ne soient stockées dans ladite au moins une mémoire tampon (40 ; 140a, 140b).

9. Appareil selon l'une quelconque des revendications 5 à 8, dans lequel l'au moins une mémoire tampon est au moins une mémoire tampon circulaire (40 ; 140a, 140b) et ledit moyen de lecture desdites données est apte à lire lesdites données à partir de ladite au moins une mémoire tampon circulaire dans un ordre inverse avant d'écrire lesdites données dans ladite RAM.

10. Appareil selon l'une quelconque des revendications 5 à 9, comprenant en outre un premier multiplexeur (50 ; 62 ; 150a, 150b ; 205) apte à fournir à ladite au moins une RAM l'adresse pour les données à stocker et un deuxième multiplexeur (52 ; 64 ; 152a, 152b ; 210) apte à fournir à ladite au moins une RAM lesdites données à stocker, dans lequel l'au moins une mémoire tampon (40 ; 60 ; 140a, 140b) est connectée aux premier et deuxième multiplexeurs pour fournir l'adresse et les données stockées dans la mémoire tampon à ladite au moins une RAM.
